# EUROPÄISCHE PATENTSCHRIFT

(11) **EP 1 586 117 B1**
(45) Veröffentlichungstag und Bekanntmachung des Hinweises auf die Patenterteilung: **18.06.2014**
(21) Anmeldenummer: 03709608.8
(22) Anmeldetag: 13.02.2003
(51) Int. Cl.: H01L 21/98, H01L 21/48, H01L 23/538

(54) **VERFAHREN ZUR HERSTELLUNG VON MIKROSYSTEMEN**
METHOD FOR PRODUCING MICROSYSTEMS
PROCEDE DE PRODUCTION DE MICROSYSTEMES

(30) Priorität: 17.01.2003 DE 10301612
(43) Veröffentlichungstag der Anmeldung: 19.10.2005
(73) Patentinhaber: microTec Gesellschaft für Mikrotechnologie mbH, 47057 Duisburg (DE)
(72) Erfinder: Götzen, Reiner, 47239 Duisburg (DE)
(74) Vertreter: Röther, Peter
(86) Internationale Anmeldenummer: PCT/DE2003/000419
(87) Internationale Veröffentlichungsnummer: WO 2004/070835

(56) Entgegenhaltungen:
- WO-A-00/67538
- DE-A- 4 223 371
- DE-A- 19 826 971
- DE-A- 19 847 088
- US-A- 3 712 735
- US-A- 6 002 592
- US-A- 6 160 714
- US-B1- 6 495 214

## Beschreibung

Die Erfindung betrifft ein Verfahren zur Herstellung von Mikrosystemen mit Kavitäten, die nebeneinander und/oder in mehreren Ebenen übereinander im schichtweise aus photoaushärtbarem Material aufgebauten Grundkörper bei dessen Aufbau ausgespart und in die mikroelektronische Bauteile eingelegt werden, die elektrisch oder thermisch leitend miteinander verbunden werden, wobei nach dem Einsetzen des elektronischen Bauteils eine Kavität mit dem schichtweisen Aufbau des Grundkörpers fortgefahren wird, über den als Pads bezeichneten Kontakten des elektronischen Bauteils jedoch vertikal aufsteigend eine Struktur aus elektrisch oder thermisch leitendem Material aufgebaut wird, wobei dieses leitende Material eine direkte Verbindung mit einem oberhalb des elektronischen Bauelements anzuordnenden weiteren elektronischen Bauelement herstellt bzw. wobei mittels einer horizontal verlaufenden Leiterbahn vom vom Pad aufsteigenden leitenden Material zu einem oder mehreren vom elektronischen Bauteil seitlich entfernt angeordneten weitern elektronischen Bauteil/Bauteilen die leitende Verbindung hergestellt wird.

Darüber hinaus betrifft die Erfindung eine Vorrichtung zur Durchführung des Verfahrens.

Ein derartiges Verfahren ist beispielsweise aus der DE 198 26 971 A bekannt, bei dem der schichtweise Aufbau von aus photoaushärtbarem Material bestehenden Mikrostrukturen und komplexen Mikrosystemen mittels eines aus der DE-PS 44 20 996 bekannten Verfahrens erfolgt. Bei dem dort beschriebenen Verfahren ist zwischen zwei planparallelen Platten allein durch die Oberflächenspannung gehalten eine photoaushärtbare Flüssigkeit. Eine der Platten ist für elektromagnetische Wellen durchlässig.

In einem PC ist das 3D-Modell in einzelne virtuelle Schichten zerlegt gespeichert. Durch Abrufen der einzelnen Schichten wird die Schichtstruktur mittels einer elektromagnetische Wellen aussendenden Quelle durch die planparallele Platte auf die angrenzende Flüssigkeitsschicht übertragen. Belichtete Flächen härten dabei aus, während die nicht belichteten, flüssig gebliebenen Bereiche entfernt werden. Nach Fertigstellung dieser Schicht werden die Platten um eine weitere Schichtdicke auseinander bewegt, wodurch Flüssigkeit nachfließt und ein erneuter Belichtungsvorgang stattfinden kann.

Mit Hilfe dieser Technik ist es jedoch nicht möglich, Mikrostrukturen in größerer Stückzahl herzustellen, da in jeder Vorrichtung jeweils nur eine begrenzte Anzahl von Mikrostrukturen generiert werden kann.

Daher hat der Erfinder in der nicht vorveröffentlichten Patentanmeldung 101 44 579.2 vorgeschlagen, statt der planparallelen Platten ein Walzenpaar vorzusehen, an das sich weitere Walzenpaare anschließen können.

Mit dieser Vorrichtung werden die einzelnen Schichten der aufzubauenden Struktur zwischen jeweils zwei sich gegenüberstehenden, die Begrenzungsflächen bildenden Walzen generiert, wobei der Walzenabstand des jeweiligen Walzenpaares durch die Dicke der zu bildenden Schicht und der Dicke der bereits vorhandenen Schichten gegeben ist. Die erste Schicht wird dabei auf einer zwischen den Walzen hindurchfahrenden Substratträgerfolie aufgebracht und die Belichtung der zu generierenden Schicht erfolgt durch eine der Walzen.

Diese Walze beinhaltet die elektromagnetische Wellen aussendende Quelle. Die Belichtung der zwischen den Walzen vorhandenen photoaushärtbaren Flüssigkeit erfolgt durch eine der jeweiligen Schichtstruktur entsprechenden Maske, die auf der Oberfläche der jeweiligen Belichtungswalze aufgebracht sein kann, aber auch als separate Folie zwischen den Walzen des Walzenpaares hindurchgeführt werden kann.

In einer derartigen vorrichtung sind den Walzenpaaren Spülvorrichtungen nachgeschaltet, in denen das nicht ausgehärtete Material ausgespült wird. Weitere Stationen sind vorgesehen, um in der bereits aufgebauten Struktur vorhandene Kavitäten beispielsweise mit elektronischen Bauelementen zu füllen. Nach Einsetzen des jeweiligen elektronische Bauelements wird der Aufbau der Mikrostruktur dann fortgesetzt. Ein derartiges Verfahren erinnert an den Rotationsdruck, mit dem es den gemeinsamen Vorteil hat, große "Auflagen" in kürzester Zeit zu erstellen.

Bisher ist es jedoch schwierig, die einzelnen elektronischen Bauelemente elektrisch bzw. thermisch leitend miteinander zu verbinden, was sowohl für elektronische Bauelemente in der gleichen Ebene aber auch für elektronische Bauelemente in verschiedenen Ebenen betrifft.

Der Erfindung liegt daher die Aufgabe zugrunde, ein Verfahren der eingangs genannten Art so zu führen, dass während des Aufbaus der Mikrostruktur auch gleichzeitig die elektrisch bzw. thermisch leitenden Verbindungen zwischen einzelnen elektronischen Bauelementen erfolgen kann und in kurzer Zeit große Stückzahlen zu erhalten.

Die Erfindung löst diese Aufgabe gemäß dem kennzeichnenden Teil des Anspruchs 1 dadurch, dass der schichtweise Aufbau des Mikrosystems zwischen mindestens einem Paar von Walzen erfolgt, wobei der Bereich zwischen den Walzen mit einer fotoaushärtbaren Flüssigkeit gefüllt ist und die Belichtung der jeweiligen Flüssigkeitsschicht durch eine der Walzen und eine der jeweiligen Schichtstruktur entsprechenden Maske erfolgt.

Die vorliegende Erfindung ermöglicht es somit, ohne Unterbrechung des Strukturaufbaus des Mikrosystems, praktisch integriert in das Verfahren, die leitenden verbindungen sowohl in vertikaler als auch in horizontaler Richtung zu generieren.

In der Alternative gemäß Anspruch 2 wird vorgeschlagen, dass die leitende, vertikal aufsteigende Struktur in oberhalb der Pads freigelassenen Öffnungen in aufeinanderfolgenden Schichten mittels Siebdruck generiert wird, dabei die in den Schichten des photoaushärtbaren Materials oberhalb der Pads gelassenen Öffnungen mit dem elektrisch leitenden Material ausfüllend, wonach abschließend die horizontal verlaufende Leiterbahn gedruckt wird.

Als besonders geeignet für dieses Siebdruckverfahren hat sich ein elektrisch leitende Kleber herausgestellt (Anspruch 3). Durch die Klebeeigenschaften ergibt sich zum einen ein guter elektrischer Kontakt zum Pad als auch beim Aufbau der leitenden Struktur der Schichten untereinander.

Die horizontal verlaufenden Leiterbahnen führen zu einem seitlich vom ersten Bauteil angeordneten Bauteil. Durch Fortsetzung des Verfahrens kann die Struktur dann weiter aufgebaut werden, wobei nun von diesem seitlich angeordneten Bauteil gemäß dem Verfahren aus Anspruch 2 weitere Verbindungen nach oben erzeugt werden.

Zur schnelleren Aushärtung des leitenden Klebers ist eine Heizquelle vorgesehen, die beispielsweise aus einem Durchlaufofen bestehen kann.

Um bei den auf diese Weise erzeugten Mikrosystemen große Packungsdichten realisieren zu können, ist es wünschenswert, wenn die elektronischen Bauelemente nicht nur von oben -wie gerade beschrieben- kontaktiert werden können, sondern wenn auch die Möglichkeit einer Kontaktierung von unten gegeben werden kann. Das heißt, dass eine direkte elektrisch leitende Verbindung zwischen übereinander angeordneten elektronischen Bauteilen (beispielsweise Chips) hergestellt werden kann.

Die Erfindung wird im folgenden anhand von Zeichnungen dargestellt und erläutert.

Es zeigen
- Fig. 1: Walzenpaar bei der Erzeugung einer ersten Substratschicht
- Fig. 2: Walzenpaar gemäß Figur 1 mit Maskenfolie
- Fig. 3: Walzenpaar bei der Erzeugung der zweiten Schicht
- Fig. 4: Walzenpaar und Zuführvorrichtung von einzulegenden Bauteilen
- Fig. 5: Walzenpaar mit Zuführung einer Folie
- Fig. 6: Aufbau einer Struktur aus photoaushärtbarem Material mit Leiterbahnen aus leitendem Kleber
- Fig. 7a-e: Verfahrensschritte zur Herstellung einer leitenden Verbindung zwischen zwei elektronsichen Bauteilen übereinander.

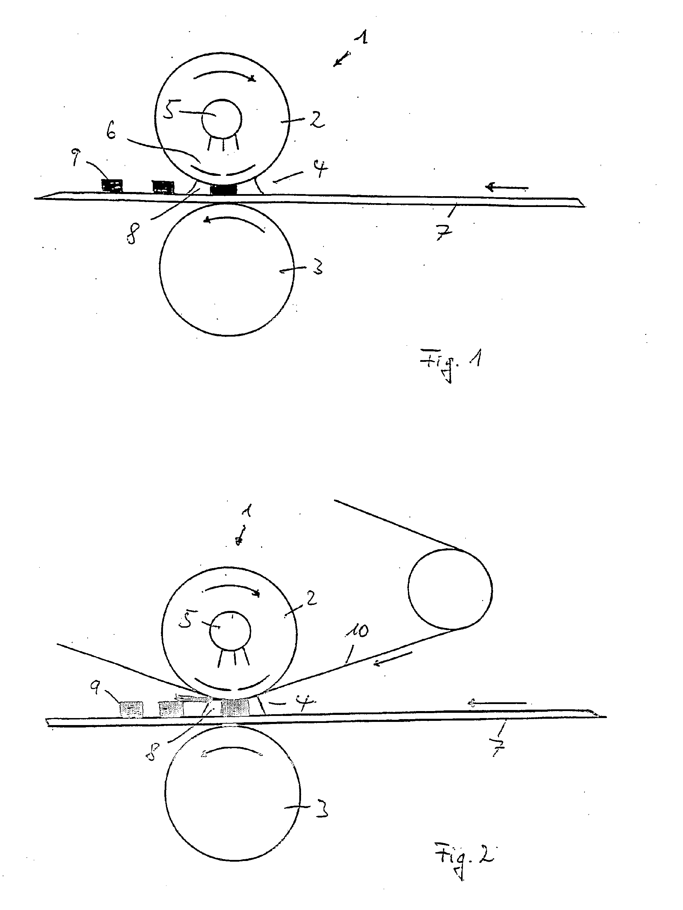

In den Figuren 1 bis 5 ist jeweils ein Walzenpaar dargestellt und allgemein mit dem Bezugszeichen 1 versehen. Für die erfindunngsgemäße Vorrichtung muss man sich n dieser Walzenpaare in Reihe zueinander geschaltet vorstellen, wobei n abhängig ist von der Strukturhöhe bzw. von den Eigenschaften, die eine derartige Struktur haben soll. Alternativ kann aber auch ein Walzenpaar vorgesehen sein, bei dem bei jedem Durchlauf der Abstand der Walzen um die Schichtdicke erhöht wird.

In der Figur 1 ist das erste Walzenpaar innerhalb der Vorrichtung dargestellt. Es besteht (wie im Prinzip die anderen Walzenpaare auch) aus einer auf für elektromagnetische Wellen durchlässigem Material bestehenden Belichtungswalze 2 und einer Gegenwalze 3, die zwischen sich einen Walzenspalt 4 lassen. In der Belichtungswalze 2 ist eine elektromagnetische Wellen aussendende Quelle 5 (UV-Quelle, Laser etc.) angeordnet. Zwischen Lichquelle 5 und dem Walzenspalt 4 befindet sich in der Walze 2 ein stationärer Belichtungsschlitz 6. Durch den Walzenspalt hindurchgeführt wird eine Substratträgerfolie 7, zwischen welcher und der Belichtungswalze 2 eine durch Adhäsionskräfte gehaltene fotoaushärtbare Flüssigkeit 8 vorgesehen ist. Auf der Oberfläche der Belichtungswalze 2 ist eine Maske (beispielsweise Chrom-Glas-Maske) aufgetragen, die ein Negativ zur Schicht-Topographie der zu erzeugenden ersten Schicht darstellt.

Die Flüssigkeit 8 wird mit Hilfe der Lichtquelle 5 durch den Belichtungsschlitz 6 belichtet. Dort wo das Licht in die Flüssigkeit eindringen kann (D.h. von der Maske nicht ausgeblendet wird), polymerisiert die Flüssigkeit und wird fest. Hierdurch entsteht die erste Schicht 9 der zu generierenden Struktur.

In der Figur 2 ist eine an sich gleiche Vorrichtung dargestellt. Hier ist die Maske aber nicht auf der Oberfläche der Belichtungswalze 2 aufgetragen, sondern wird in der Form einer Belichtungsfolie 10 zwischen Belichtungsschlitz und Flüssigkeitsoberfläche hindurchgeführt.

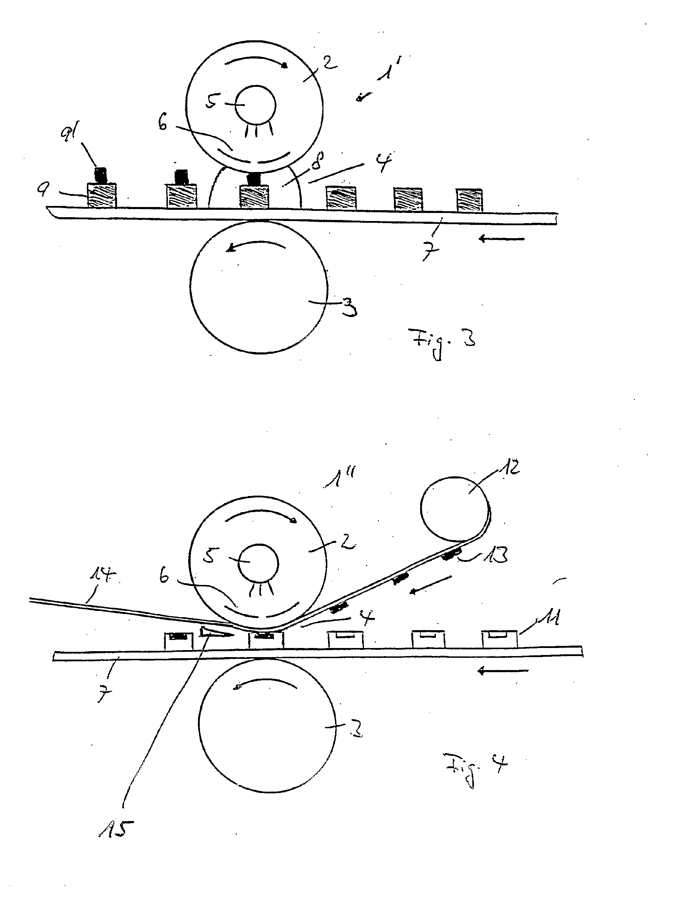

In der Figur 3 ist ein dem in den Figuren 1 und 2 dargestellten Walzenpaar 1 nachgeordnetes Walzenpaar 1' dargestellt, durch welches die zweite Schicht 9' auf der ersten Schicht 9 in gleicher Weise generiert wird wie diesbezüglich in Fig. 1 und 2 beschrieben. Die Substanz zur Erzeugung der zweiten Schicht 9' kann dabei gleich sein wie die Substanz der ersten Schicht 9, kann aber auch aus anderem Material mit abweichenden Eigenschaften bestehen.

In der Figur 4 ist wiederum ein Walzenpaar 1" dargestellt, an dem bereits mit einer Mulde versehene zuvor generierte Strukturen 11 ankommen und dort mit von einer Spule 112 zugeführten (beispielsweise) Bauteilen 13 bestückt werden. Die Bauteile 13 haften auf einer Folie 14. Nach dem Einlegen der Bauteile 13 in die Mulden der Struktur 11 werden diese mittels eines Schälmesser 16 von der Folie 14 abgeschält. Zum Befestigen der Teile 13 in den Mulden können Klebetechniken angewandt werden, bei denen ebenfalls mit fotoaushärtbaren Substanzen gearbeitet wird, und zwar in der Art und Weise wie oben beschrieben.

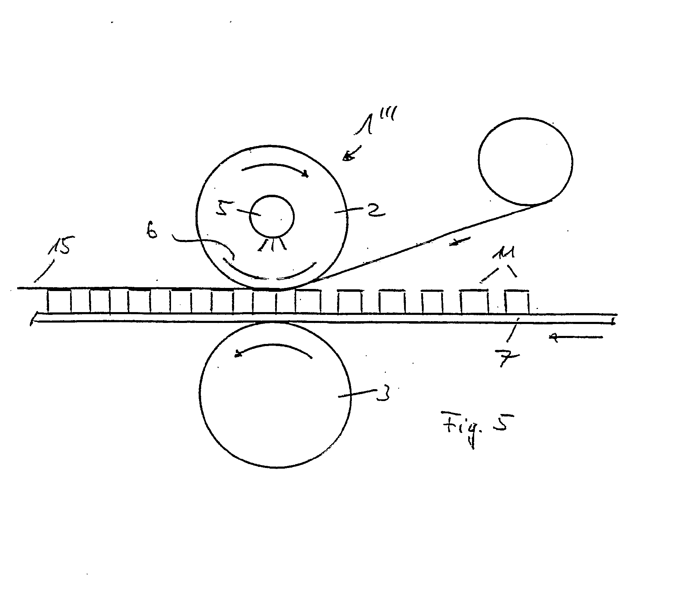

Schließlich ist in Figur 5 ein abschließenden Walzenpaar 1"' dargestellt, in dem die fertigen Strukturen 11 zum Schutz und zum Transport mit einer Deckfolie 15 abgedeckt werden. Auch hierbei kann mittels des obengenannten Verfahrens eine Verklebung der Folie mit den Strukturen 11 erfolgen.

Abhängig von chemikalischen, pyhsikalischen und biologischen Eigenschaften können ähnlich wie in Fig. 5 dargestellt auch bei der Produktion, d.h. bei der Generierung der Strukturen 11 Folien zugeführt werden, die dann einzelne Schichten der Struktur bilden.

Die Erfindung ist jedoch auf die in den Figuren 1 bis 5 dargestellten Ausführungsformen nicht beschränkt.

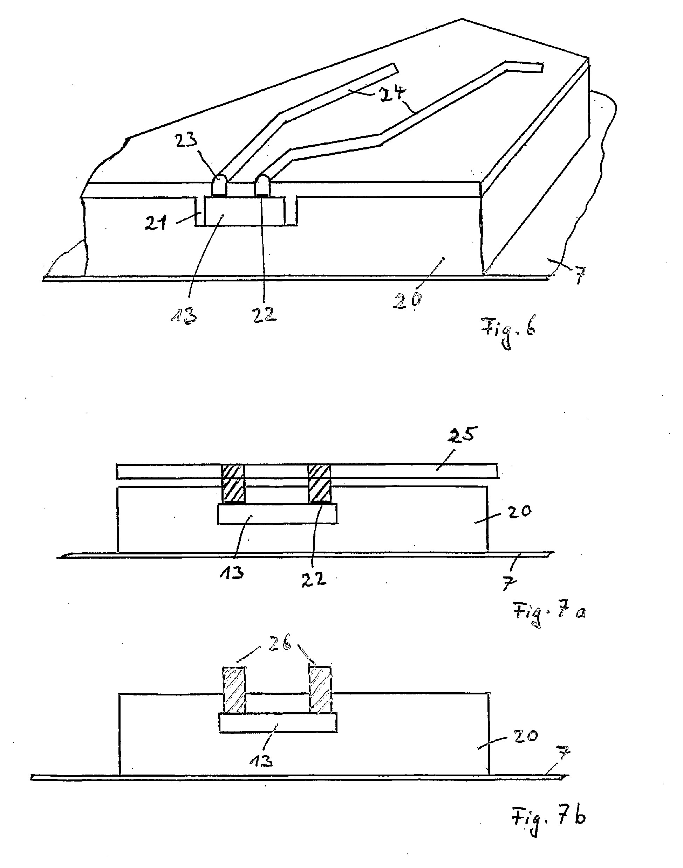

In der Figur 6 ist eine bereits weit fortgeschrittene Struktur eines Mikrosystems dargestellt, die schichtweise auf einer Folie aufgebaut ist. Der aufgebaute Grundkörper ist mit, dem Bezugszeichen 20 versehen. Während des Aufbaus des Grundkörpers 20 ist in diesem eine Kavität 21 freigelassen, in der ein elektronisches Bauelement 13, (in diesem Fall ein Mikrochip) eingesetzt worden ist. Beim weiteren Aufbau der Grundkörperstruktur 20 werden oberhalb der Pads 22 in den einzelnen Schichten Öffnungen gelassen, die Schicht für Schicht mittels eines leitenden Klebers im Siebdruckverfahren verfüllt werden. So entsteht eine vertikal aufsteigende Struktur 23 aus einem leitenden Material, von der dann (wie in der Zeichnung dargestellt) ebenfalls mittels Siebdruckverfahren eine Leiterbahn 24, die horizontal verläuft, auf die aktuell letzte Schicht des Grundkörpers 20 aufgebracht wird. Diese Leiterbahn (bzw. diese Leiterbahnen) führen zu weiteren elektronischen Bauelementen oder zu seitlichen Kontakten, wodurch elektrische Funktionen realisiert werden.

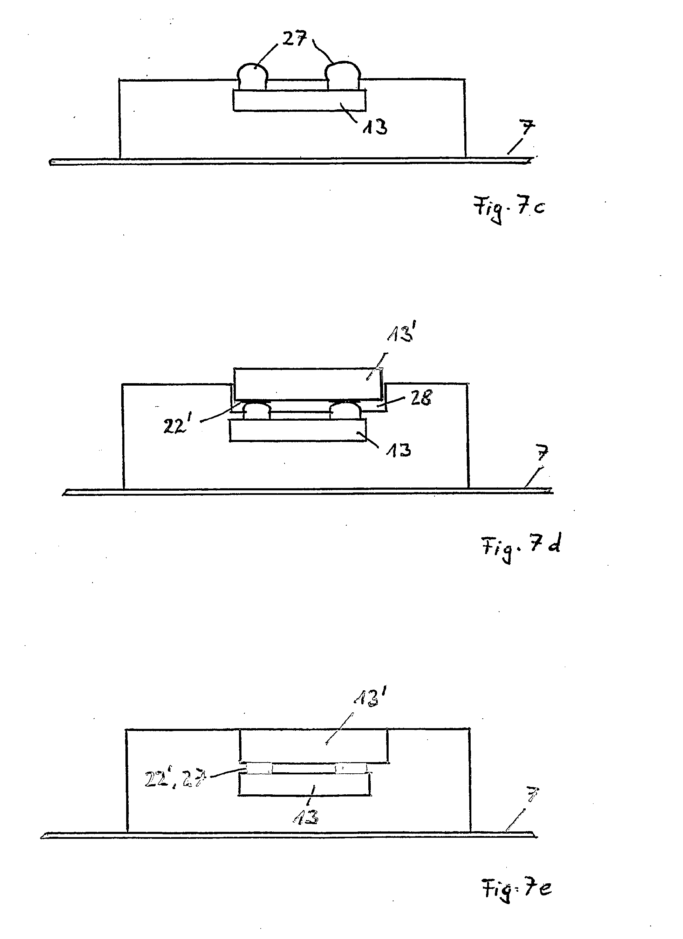

In der Figur 7 ist dargestellt, wie zwei elektronische Bauelemente (in diesem Fall zwei Mikrochips) vertikal übereinander direkt miteinander leitend verbunden werden können.

In der Figur 7a ist der Zustand dargestellt, in dem ähnlich wie in Figur 6 auf der Folie 7 ein Grundkörper 20 aufgebaut ist, in dem in einer entsprechenden Kavität bereits ein Mikrochip 13 eingesetzt ist. Die elektrischen Anschlüsse (Pads) 22 weisen nach oben. Oberhalb dieser PADS 22 sind im Material des Grundkörpers 20 Öffnungen gelassen, die mit Öffnungen in einer Schablone 25 korrespondieren. Über die Öffnungen der Schablone 25 wird nun Lötpaste gegeben, die den Raum oberhalb der Pads 22 ausfüllt.

Figur 7b zeigt den Zustand nach Entfernung der Schablone 25. Zurückgeblieben sind oberhalb der Pads 22 Lötpastenhäufchen 26.

In einer nachfolgenden Station werden die Lötpastenhäufchen 26 erhitzt, so dass die Lötpaste flüssig wird und sogenannte Bumps 27 bilden. Dieser Zustand ist in Figur 7c dargestellt.

In der Figur 7d ist der Grundkörper 20 weiter aufgebaut, wobei eine zusätzliche Kavität 28 entstanden ist, in die nun ein weiterer Mikrochip 13' mit den Pads 22' nach unten eingelegt wird. Die Pads 22' liegen auf den wieder erstarrten Lötbumps 27 auf.

In einer anschließenden Walzenvorrichtung, in der eine der Walzen mit einer Heizvorrichtung versehen ist, wird nun der zweite Mikrochip 13' in die Kavität 28 eingedrückt, wobei infolge der Erhitzung die Lötbumps wieder flüssig werden und elektrischen Kontakt zu den Pads 22' herstellen.

Dieser Zustand ist in der Figur 7e dargestellt.

Hiernach kann der weitere schichtweise Aufbau der Mikrostruktur bzw. des Mikrosystem wie eben beschrieben weitergehen, wobei die Alternativen aus Figur 6 und Figur 7a bis e auch miteinander kombiniert werden können.

## Patentansprüche

1. Verfahren zur Herstellung von Mikrosystemen mit Kavitäten, die nebeneinander und/oder in mehreren Ebenen übereinander im schichtweise aus fotoaushärtbarem Material aufgebauten Grundkörper bei dessen Aufbau ausgespart und in die mikroelektronische Bauteile eingelegt werden, die elektrisch oder thermisch leitend miteinander verbunden werden, wobei nach dem Einsetzen des elektronischen Bauteils (13) in eine Kavität mit dem schichtweisen Aufbau des Grundkörpers (20) fortgefahren wird, über den Kontakten (22,22')-auch als Pads bezeichnet- des elektronischen Bauteils jedoch vertikal aufsteigend eine Struktur (23,26) aus elektrisch oder thermisch leitendem Material aufgebaut wird, wobei dieses leitende Material eine direkte Verbindung mit einem oberhalb des elektronischen Bauelements anzuordnenden weiteren elektronischen Bauelement (13') herstellt bzw. wobei mittels einer horizontal verlaufenden Leiterbahn (24) vom vom Pad (22) aufsteigenden leitenden Material zu einem oder mehreren vom elektronischen Bauteil seitlich entfernt angeordneten weiteren elektronischen Bauteil/Bauteilen die leitende Verbindung hergestellt wird,
**dadurch gekennzeichnet, dass** der schichtweise Aufbau des Mikrosystems zwischen mindestens einem Paar von Walzen (1,1', 1",1"') erfolgt, wobei der Bereich zwischen den Walzen mit einer fotoaushärtbaren Flüssigkeit gefüllt ist und die Belichtung der jeweiligen Flüssigkeitsschicht durch eine der Walzen und eine der jeweiligen Schichtstruktur entsprechende Maske erfolgt.

2. Verfahren nach Anspruch 1, **dadurch gekennzeichnet, dass** die leitende, vertikal aufsteigende Struktur in oberhalb der Pads (22) freigelassenen Öffnungen in aufeinander folgenden Schichten mittels Siebdruck generiert wird, dabei die in den Schichten des fotoaushärtbaren Materials oberhalb der Pads (22) gelassenen Öffnungen mit dem elektrisch leitenden Material ausfüllend, wonach abschließend die horizontal verlaufende Leiterbahn (24) gedruckt wird.

3. Verfahren nach Anspruch 2, **dadurch gekennzeichnet, dass** das leitende Material ein Kleber ist.

4. Vorrichtung zur Durchführung des Verfahrens nach einem der Ansprüche 1 bis 3
**gekennzeichnet durch** mindestens ein Walzenpaar (1,1',1".1"'), bei dem der Abstand zwischen den Walzen (2, 3) veränderbar ist, wobei jeweils eine walze (2) des Walzenpaares (1,1',1",1"') als Belichtungswalze aus einem für elektromagnetische Wellen durchlässigen Material besteht, wobei in dieser Walze (2) eine elektromagnetische Wellen aussendende Quelle (5) als Lichtquelle angeordnet ist, einer jeder Belichtungswalze (2) zugeordneten Maske (10) mit für elektromagnetische Wellen durchlässigen und undurchlässigen Bereichen, sowie durch eine **durch** das mindestens eine Walzenpaar (1,1',1",1"') hindurch geführte Substrat -Trägerfolie (7) als Basis für die generierten Strukturen (11), wobei dem mindestens einen Walzenpaar (1,1',1",1"') Spülvorrichtungen sowie mindestens eine Siebdruckvorrichtung nachgeschalte ist.

5. Vorrichtung nach Anspruch 4,
**dadurch gekennzeichnet, dass** die Maske auf die Oberfläche der Belichtungswalze (2) aufgebracht ist.

6. vorrichtung nach Anspruch 4, **dadurch gekennzeichnet, dass** in der Belichtungswalze (2) zwischen Lichtquelle (5) und Walzenoberfläche ein stationärer Belichtungsschlitz (6) angeordnet ist und die Maske als unterhalb des Schlitzes (6) an der Oberfläche der Belichtungswalze (2) vorbei geführtes Folienband (10) ausgebildet ist.

7. Vorrichtung nach einem der Ansprüche 5 oder 6, **dadurch gekennzeichnet, dass** mehrere Walzenpaare in Reihe hintereinander angeordnet sind.

8. Vorrichtung nach einem der Ansprüche 5 bis 7, **dadurch gekennzeichnet, dass** zwischen den Walzenpaaren (1,1',1",1"') Folienwickel (112,15) angeordnet sind, deren Folien als Träger für eine Klebstoffschicht und/oder elektrische und/oder elektronische und/oder mechanische und/oder optische und/oder biologische Bauteile (13) ausgebildet sind.

9. Vorrichtung nach einem der Ansprüche 5 bis 7, **dadurch gekennzeichnet, dass** zwischen den Walzenpaare (1,1',1",1"') Folienwickel angeordnet sind, wobei die Folien gleiche oder verschiedene physikalische bzw. chemische Eigenschaften aufweisen.

10. Vorrichtung nach einem der Ansprüche 5 bis 9, **dadurch gekennzeichnet, dass** zumindest die Belichtungswalze (2) mit einer Antihaftbeschichtung versehen ist.

11. Vorrichtung nach einem der Ansprüche 5 bis 10, **dadurch gekennzeichnet, dass** dem mindestens einen Walzenpaar (1,1',1",1"') mindestens eine Heizvorrichtung nach geschaltet ist.

## Claims

1. Method for producing microsystems with cavities which are created in the base body consisting of a photocurable material formed in layers, wherein said cavities are adjacent to each other and/or are in several planes one above the other and into which microelectronic components are inserted which are connected to each other electrically or thermally, wherein, after the insertion of the electronic component (13) into a cavity, the layered construction of the base body (20) continues, projecting vertically however above the contacts (22,22') - also called pads - of the electronic component a structure (23,26) consisting of an electrically or thermally conducting material is constructed, wherein this conducting material produces a direct connection with a further electronic component (13') arranged above the electronic component, or wherein the conducting connection is produced by means of a conductor track (24) running horizontally from the conducting material projecting above the pad (22) to one or several further electronic component(s) arranged at a lateral distance from the electronic component, **characterised in that** the layered construction of the microsystem is done between at least one pair of rollers (1, 1', 1", 1"'), wherein the region between the rollers is filled with a photocurable liquid and the exposure of the liquid in question is done through one of the rollers and through a mask corresponding to the particular layered structure.

2. Method in accordance with claim 1, **characterised in that** the conducting, vertically projecting structure is generated by silk screen printing in openings formed above the pads (22) in superimposed layers, thereby filling the openings left in the layers of the photocurable material above the pads (22) with the electrically conducting material, after which the horizontally moving conducting track (24) is finally compressed.

3. Method in accordance with claim 2, **characterised in that** that the conducting material is an adhesive.

4. Device to perform the method in accordance with one of claims 1 to 3,
**characterised by** at least one pair of rollers (1, 1', 1", 1"') in which the gap between the rollers (2, 3) can be changed, wherein each roller (2) of the pair of rollers (1, 1', 1", 1"') consists of a material permeable to electromagnetic waves to form the exposure roller, wherein, in this roller (2), a source (5) for emitting electromagnetic waves as a light source is arranged, of a mask (10) assigned to each exposure roller (2) with regions permeable and impervious to electromagnetic waves, and by a substrate carrier film (7) guided right through the at least one pair of rollers (1, 1', 1", 1"') to form a basis for the generated structures (11), wherein rinsing devices and at least one silk screen printing device are connected in series to the at least one pair of rollers (1, 1', 1", 1"').

5. Device in accordance with claim 4,
**characterised in that** the mask is attached to the upper surface of the exposure roller (2).

6. Device in accordance with claim 4,
**characterised in that** a stationary exposure slit (6) is arranged in the exposure roller (2) between the light source (5) and the upper face of the roller and the mask is formed as a film band (10) guided through, underneath the slit (6) on the upper surface of the exposure roller (2).

7. Device in accordance with one of claims 5 or 6, **characterised in that** several pairs of rollers are arranged in line one behind the other.

8. Device in accordance with one of claims 5 to 7, **characterised in that,** between the pairs of rollers (1, 1', 1", 1"'), film winders (112, 15) are arranged whose films are formed as carriers for an adhesive layer and/or electrical and/or electronic and/or mechanical and/or optical and/or biological components (13).

9. Device in accordance with one of claims 5 to 7, **characterised in that** between the pairs of rollers (1, 1', 1", 1"'), film winders are arranged wherein the films have the same or different physical or chemical properties.

10. Device in accordance with one of claims 5 to 9, **characterised in that** at least one of the exposure rollers (2) is provided with a non-stick coating.

11. Device in accordance with one of claims 5 to 10, **characterised in that** at least one heating device is connected in series to at least one pair of rollers (1, 1', 1", 1"').

## Revendications

1. Procédé de production de microsystèmes ayant des cavités qui sont disposées, lors de leur construction, les unes à côté des autres et/ou les unes au-dessus des autres dans plusieurs plans dans un corps de base constitué d'une matière photodurcissable et organisé en couches, et dans lesquelles sont insérés des composants micro-électroniques qui sont reliés les uns aux autres de manière électriquement ou thermiquement conductrice, dans lequel, après l'insertion du composant électronique (13) dans une cavité, la construction en couches du corps de base (20) est poursuivie, une structure (23, 26) en matériau électriquement ou thermiquement conducteur, verticalement montante, étant toutefois assemblée au-dessus des contacts (22, 22') - également appelés plots - du composants électronique, dans lequel ce matériau conducteur établit une connexion directe avec un autre composant électronique (13') disposé au-dessus du composant électronique, ou dans lequel la connexion conductrice est créée au moyen d'une piste conductrice s'étendant horizontalement (24) à partir du matériau conducteur qui s'élève à partir du plot (22) jusqu'à un ou plusieurs composants électroniques supplémentaires disposés à une certaine distance latérale du composant électronique,
**caractérisé en ce que** la construction en couches du microsystème s'effectue entre au moins une paire de rouleaux (1, 1', 1", 1"'), dans lequel la région entre les rouleaux est remplie d'un liquide photodurcissable, et l'exposition de la couche de liquide respective s'effectue au moyen de l'un des rouleaux et d'un masque correspondant à la structure de couche respective.

2. Procédé selon la revendication 1, **caractérisé en ce que** la structure conductrice, verticalement montante, est générée par sérigraphie dans des ouvertures laissées libres au-dessus der plots (22) dans des couches consécutives, les ouvertures laissées dans les couches du matériau photodurcissable au-dessus des plots (22) étant ainsi remplies du matériau électriquement conducteur, après quoi finalement la piste conductrice s'étendant horizontalement (24) est imprimée.

3. Procédé selon la revendication 2, **caractérisé en ce que** le matériau conducteur est un adhésif.

4. Dispositif pour mettre en oeuvre de procédé selon l'une des revendications 1 à 3,
**caractérisé par** au moins une paire de rouleaux (1, 1', 1", 1"'), dans lequel la distance entre les rouleaux (2, 3) peut être changée, dans lequel un rouleau (2) de la paire de rouleaux (1, 1', 1", 1"') faisant office de rouleau d'exposition, est respectivement constitué d'un matériau perméable aux ondes électromagnétiques, dans lequel une source (5) émettrice d'ondes électromagnétiques, faisant office de source de lumière, est disposée dans ce rouleau (2), un masque (10) correspondant à chaque rouleau d'exposition (2) ayant des régions perméables et non perméables aux ondes électromagnétiques, ainsi que par un film de support de substrat (7), servant de base pour les structures (11) générées, passé à travers la au moins une paire de rouleaux (1, 1', 1", 1"'), dans lequel des dispositifs à enroulements suivent la au moins une paire de rouleaux (1, 1', 1", 1"') ainsi qu'au moins un dispositif de sérigraphie.

5. Dispositif selon la revendication 4,
**caractérisé en ce que** le masque est appliqué sur la surface du rouleau d'exposition (2).

6. Dispositif selon la revendication 4, **caractérisé en ce qu'**une fente d'exposition fixe (6) est disposée dans le rouleau d'exposition (2) entre la source de lumière (5) et la surface de rouleau, et le masque est configuré comme une bande de film (10) qui est passée sur la surface du rouleau d'exposition (2), sous la fente (6).

7. Dispositif selon l'une des revendications 5 ou 6, **caractérisé en ce que** plusieurs paires de rouleaux sont disposées en série les unes derrière les autres.

8. Dispositif selon l'une des revendications 5 à 7, **caractérisé en ce qu'**entre les paires de rouleaux (1, 1', 1", 1"') sont disposés des enroulements de film (112, 15) dont les films sont configurés comme des supports pour une couche adhésive et/ou des composants électriques et/ou électroniques et/ou mécaniques et/ou optiques et/ou biologiques (13).

9. Dispositif selon l'une des revendications 5 à 7, **caractérisé en ce qu'**entre les paires de rouleaux (1, 1', 1", 1"') sont disposés des enroulements de film, dans lequel les films présentent des propriétés physiques ou chimiques identiques ou différentes.

10. Dispositif selon l'une des revendications 5 à 9, **caractérisé en ce qu'**au moins le rouleau d'exposition (2) est muni d'une couche anti-adhésive.

11. Dispositif selon l'une des revendications 5 à 10, **caractérisé en ce qu'**au moins un dispositif de chauffage suit la au moins une paire de rouleaux (1, 1', 1", 1"').
